(19) Europäisches Patentamt
European Patent Office
Office européen des brevets

(11) **EP 4 306 975 A1**

(12) **EUROPEAN PATENT APPLICATION**

(43) Date of publication:
**17.01.2024 Bulletin 2024/03**

(21) Application number: **23178767.2**

(22) Date of filing: **12.06.2023**

(51) International Patent Classification (IPC):
**G01R 31/3185** (2006.01)  **G01R 31/28** (2006.01)
**H01L 21/66** (2006.01)

(52) Cooperative Patent Classification (CPC):
**G01R 31/318511; G01R 31/2831; H01L 22/14;**
**H01L 22/20**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **13.07.2022 US 202263388658 P**
**07.06.2023 US 202318207122**

(71) Applicant: **MediaTek Inc.**
**Hsin-Chu 300 (TW)**

(72) Inventors:
• **SHIEH, Jia-Horng**
**30078 Hsinchu City (TW)**

• **TSAO, Po-Chao**
**30078 Hsinchu City (TW)**
• **LEE, Ming-Cheng**
**30078 Hsinchu City (TW)**
• **LEE, Tung-Hsing**
**30078 Hsinchu City (TW)**
• **LEE, Chi-Ming**
**30078 Hsinchu City (TW)**
• **TING, Yi-Ju**
**30078 Hsinchu City (TW)**

(74) Representative: **Haseltine Lake Kempner LLP**
**Cheapside House**
**138 Cheapside**
**London EC2V 6BJ (GB)**

(54) **METHOD AND APPARATUS FOR PERFORMING DIE-LEVEL ELECTRICAL PARAMETER EXTRACTION THROUGH USING ESTIMATED MAPPING RELATIONSHIP BETWEEN ELECTRICAL PARAMETERS OF TRANSISTOR TYPES AND MEASUREMENT RESULTS OF LOGIC BLOCKS**

(57)  A die-level electrical parameter extraction method includes: obtaining electrical parameters of a plurality of transistor types; obtaining measurement results of a plurality of logic blocks; estimating a mapping relationship between the electrical parameters of the plurality of transistor types and the measurement results of the plurality of logic blocks; and regarding a specific die of a wafer, obtaining die-level measurement of the plurality of logic blocks, and generating die-level electrical parameters of the plurality of transistor types according to the mapping relationship and the die-level measurement results.

FIG. 1

**(Cont. next page)**

EP 4 306 975 A1

Start

202

Obtain electrical parameters of
transistor types

204

Obtain measurement results
of logic blocks

206

Estimate mapping relationship (e.g.,
inverse matrix) between electrical
parameters of transistor types and
measurement results of logic blocks

208

Obtain die-level measurement of logic blocks in
specific die, and generate die-level electrical
parameters of transistor types for specific die
according to mapping relationship (e.g., inverse
matrix) and die-level measurement results

End

FIG. 2

**Description**

This application claims the benefit of U.S. Provisional Application No. 63/388,658, filed on July 13th, 2022. The content of the application is incorporated herein by reference.

Background

The present invention relates to an electrical parameter extraction methodology, and more particularly, to a method and apparatus for performing die-level electrical parameter extraction through using an estimated mapping relationship between electrical parameters of transistor types and measurement results of logic blocks.

Wafer-level testing plays a crucial role in integrated circuit (IC) fabrication, particularly as the cost for post-production processes increases. A defective wafer is identified by the wafer-level testing and disposed of before it undergoes post-processing. For example, a wafer acceptance test (WAT) includes numerous testing items and is a vital part of the IC fabrication process. In a foundry, WAT is performed as defined by a predetermined WAT model that specifies a number of test sites. However, the number of WAT sites on a wafer is much smaller than the number of dies fabricated in the same wafer. Hence, measurement results of WAT sites are unable to offer die-level electrical parameters of each die. Thus, there is a need for an innovative electrical parameter extraction methodology that can extract die-level electrical parameters (e.g., leakage currents of different transistor types) from die-level measurement results (e.g., measured block leakage currents of logic blocks).

Summary

One of the objectives of the claimed invention is to provide a method and apparatus for performing die-level electrical parameter extraction through using an estimated mapping relationship between electrical parameters of transistor types and measurement results of logic blocks.

According to a first aspect of the present invention, an exemplary die-level electrical parameter extraction method is disclosed. The exemplary die-level electrical parameter extraction method includes: obtaining electrical parameters of a plurality of transistor types; obtaining measurement results of a plurality of logic blocks; estimating a mapping relationship between the electrical parameters of the plurality of transistor types and the measurement results of the plurality of logic blocks; and regarding a specific die of a wafer, obtaining die-level measurement results of the plurality of logic blocks, and generating die-level electrical parameters of the plurality of transistor types according to the mapping relationship and the die-level measurement results.

According to a second aspect of the present invention, an exemplary non-transitory machine-readable medium for storing a program code is disclosed. When loaded and executed by a processor, the program code instructs the processor to perform following steps: obtaining electrical parameters of a plurality of transistor types; obtaining measurement results of a plurality of logic blocks; estimating a mapping relationship between the electrical parameters of the plurality of transistor types and the measurement results of the plurality of logic blocks; and regarding a specific die of a wafer, obtaining die-level measurement results of the plurality of logic blocks, and generating die-level electrical parameters of the plurality of transistor types according to the mapping relationship and the die-level measurement results.

These and other objectives of the present invention will no doubt become obvious to those of ordinary skill in the art after reading the following detailed description of the preferred embodiment that is illustrated in the various figures and drawings.

Brief Description of the Drawings

FIG. 1 is a die-level electrical parameter extraction system according to an embodiment of the present invention.
FIG. 2 is a flowchart illustrating a die-level electrical parameter extraction method according to an embodiment of the present invention.
FIG. 3 is a diagram illustrating a concept of the proposed die-level electrical parameter extraction according to an embodiment of the present invention.

Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

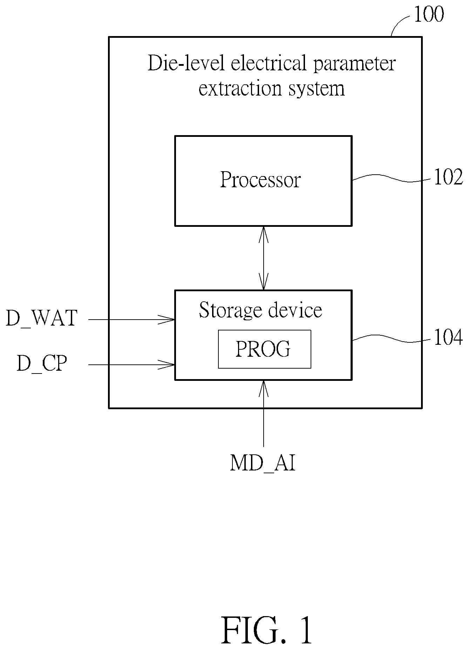

FIG. 1 is a die-level electrical parameter extraction system according to an embodiment of the present invention. The die-level electrical parameter extraction system 100 includes a processor 102 and a storage device 104. The processor 102 may be a single-core processor or a multi-core processor. The storage device 104 is a non-transitory machine-readable medium, and is arranged to store a program code PROG. The die-level electrical parameter extraction system 100 may be regarded as a computer system using a computer program product that includes a machine-readable medium containing the program code PROG. The processor 102 is equipped with software execution capability. When loaded and executed by the processor 102, the program code PROG instructs the processor 102 to perform a die-level electrical parameter extraction method proposed by the present invention. It should be noted that only the components pertinent to the present invention are illustrated in FIG. 1. In practice, the die-level electrical parameter extraction system 100 is allowed to include additional components to achieve other designated functions.

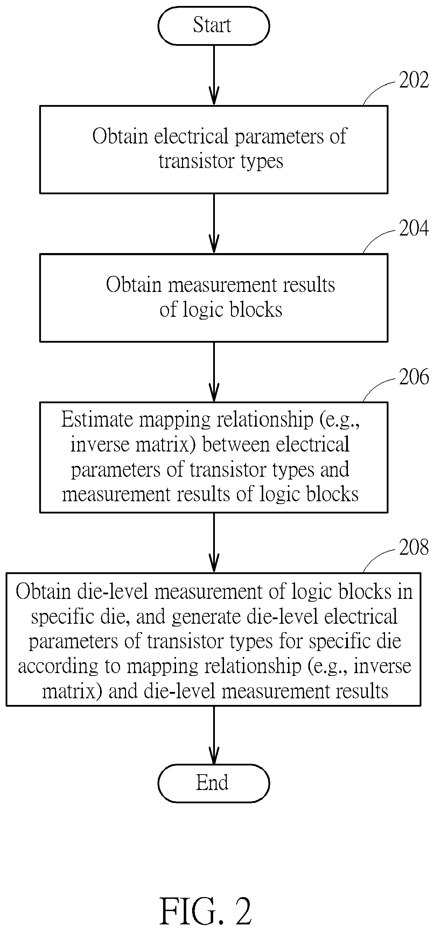

FIG. 2 is a flowchart illustrating a die-level electrical parameter extraction method according to an embodiment of the present invention. The die-level electrical parameter extraction method shown in FIG. 2 may be performed by the program code PROG running on the processor 102 of the die-level electrical parameter extraction system 100 shown in FIG. 1. Provided that the result is substantially the same, the steps are not required to be executed in the exact order shown in FIG. 2.

At step 202, the program code PROG running on the processor 102 obtains electrical parameters of a plurality of transistor types. For example, the electrical parameters of the transistor types are obtained from a wafer-level process such as a wafer acceptance test (WAT) process that is performed at the foundry. Hence, the WAT data D_WAT may be provided by the foundry and stored into the storage device 104 for further processing, where the WAT data D_WAT includes the electrical parameters of the transistor types. In this embodiment, the transistor types are differentiated by different threshold voltages Vt, and each of the electrical parameters of the transistor types is an integrated circuit quiescent current (IDDQ) of a corresponding transistor type. For example, the transistor types may include a standard Vt (SVT) transistor type, a low Vt low leakage (LVT_LL) transistor type, a low Vt (LVT) transistor type, an ultralow Vt low leakage (ULVT_LL) transistor type, an ultralow Vt (ULVT) transistor type, and an extreme low Vt (ELVT) type, and the electrical parameters of the transistor types may include different transistor types' IDDQs, that is, {SVT Iddq, LVT_LL Iddq, LVT Iddq, ULVT_LL Iddq, ULVT Iddq, ELVT Iddq}.

At step 204, the program code PROG running on the processor 102 obtains measurement results of a plurality of logic blocks. For example, measurement results of the logic blocks are obtained from a die-level measurement that may be a part of a chip probing (CP) process. Hence, the CP data D_CP may also be stored into the storage device 104 for further processing, where the CP data D_CP includes the measurement results of the logic blocks. In this embodiment, each of the measurement results of the logic blocks is a block leakage current of a corresponding logic block. For example, logic blocks included in a same die may include one or more of SOC, GPU, MCU, LCPU, MCPU, and BCPU, and the measurement results of the logic blocks may include different logic blocks' block leakage currents, that is, {CORELeak, GPULeak, MCULeak, LCPULeak, MCPULeak, BCPULeak}.

At step 206, the program code PROG running on the processor 102 estimates a mapping relationship between the electrical parameters of the transistor types (e.g., {SVT Iddq, LVT_LL Iddq, LVT Iddq, ULVT_LL Iddq, ULVT Iddq, ELVT Iddq}) and the measurement results of the logic blocks (e.g., {CORELeak, GPULeak, MCULeak, LCPULeak, MCPULeak, BCPULeak}). Each logic block may have transistors of different transistor types (i.e., transistors with different threshold voltages) . By way of example, but not limitation, power ratios contributed by different transistor types for each logic block are listed in the following table.

Table 1

| Block | SVT | LVT_LL | LVT | ULVT_LL | ULVT | ELVT |
|-------|-----|--------|-----|---------|------|------|
| SOC | 0.00% | 15.52% | 26.94% | 39.79% | 17.76% | 0.00% |
| GPU | 0.00% | 0.64% | 28.70% | 14.86% | 51.49% | 4.30% |
| MCU | 0.00% | 2.98% | 23.25% | 45.61% | 28.16% | 0.00% |
| LCPU | 0.00% | 2.24% | 56.06% | 10.47% | 31.24% | 0.00% |
| MCPU | 0.00% | 0.00% | 12.02% | 59.90% | 28.08% | 0.00% |
| BCPU | 0.24% | 0.05% | 2.46% | 9.29% | 86.03% | 1.93% |

As inspired by above observations, the present invention presumes that the electrical parameters of the transistor types (e.g., {SVT Iddq, LVT_LL Iddq, LVT Iddq, ULVT_LL Iddq, ULVT Iddq, ELVT Iddq}) and the measurement results of the logic blocks (e.g., {CORELeak, GPULeak, MCULeak, LCPULeak, MCPULeak, BCPULeak}) satisfy the following matrix formula.

$$A \times P = M$$

$$
\begin{bmatrix}
a1 & b1 & c1 & d1 & e1 & f1 \\
a2 & b2 & c2 & d2 & e2 & f2 \\
a3 & b3 & c3 & d3 & e3 & f3 \\
a4 & b4 & c4 & d4 & e4 & f4 \\
a5 & b5 & c5 & d5 & e5 & f5 \\
a6 & b6 & c6 & d6 & e6 & f6
\end{bmatrix}
\times
\begin{bmatrix}
SVT\ Iddq \\
LVT\_LL\ Iddq \\
LVT\ Iddq \\
ULVT\_LL\ Iddq \\
ULVT\ Iddq \\
ELVT\ Iddq
\end{bmatrix}
=
\begin{bmatrix}
CORELeak \\
GPULeak \\
MCULeak \\
LCPULeak \\
MCPULeak \\
BCPULeak
\end{bmatrix}
\qquad (1)
$$

If an inverse matrix $A^{-1}$ (i.e., a matrix being an inverse of the matrix A) can be found, the following matrix formula can be obtained.

$$A^{-1} \times A \times P = A^{-1} \times M = P$$

$$
\begin{bmatrix}
A1 & B1 & C1 & D1 & E1 & F1 \\
A2 & B2 & C2 & D2 & E2 & F2 \\
A3 & B3 & C3 & D3 & E3 & F3 \\
A4 & B4 & C4 & D4 & E4 & F4 \\
A5 & B5 & C5 & D5 & E5 & F5 \\
A6 & B6 & C6 & D6 & E6 & F6
\end{bmatrix}
\times
\begin{bmatrix}
CORELeak \\
GPULeak \\
MCULeak \\
LCPULeak \\
MCPULeak \\
BCPULeak
\end{bmatrix}
=
\begin{bmatrix}
SVT\ Iddq \\
LVT\_LL\ Iddq \\
LVT\ Iddq \\
ULVT\_LL\ Iddq \\
ULVT\ Iddq \\
ELVT\ Iddq
\end{bmatrix}
\qquad (2)
$$

Hence, the program code PROG running on the processor 102 is designed to find the inverse matrix $A^{-1}$ as the mapping relationship between the electrical parameters of the transistor types (e.g., {SVT Iddq, LVT_LL Iddq, LVT Iddq, ULVT_LL Iddq, ULVT Iddq, ELVT Iddq}) and the measurement results of the logic blocks (e.g., {CORELeak, GPULeak, MCULeak, LCPULeak, MCPULeak, BCPULeak}).

For example, the program code PROG running on the processor 102 may use an artificial intelligence (AI) model MD_AI for learning the mapping relationship (i.e., inverse matrix $A^{-1}$ that is a matrix being an inverse of matrix $A$). The AI model MD_AI is used to model the mapping relationship, and is trained by machine learning based on the electrical parameters of the transistor types (e.g., {SVT Iddq, LVT_LL Iddq, LVT Iddq, ULVT_LL Iddq, ULVT Iddq, ELVT Iddq}) and the measurement results of the logic blocks (e.g., {CORELeak, GPULeak, MCULeak, LCPULeak, MCPULeak, BCPULeak}), for learning the mapping relationship between the electrical parameters of the transistor types (e.g., {SVT Iddq, LVT_LL Iddq, LVT Iddq, ULVT_LL Iddq, ULVT Iddq, ELVT Iddq}) and the measurement results of the logic blocks (e.g., {CORELeak, GPULeak, MCULeak, LCPULeak, MCPULeak, BCPULeak}). Specifically, weights of the AI model MD_AI are updated iteratively to achieve the goal of minimize an error between a mapping result derived from the electrical parameters of the transistor types {SVT Iddq, LVT_LL Iddq, LVT Iddq, ULVT_LL Iddq, ULVT Iddq, ELVT Iddq} and the real data (i.e., measurement results of the logic blocks {CORELeak, GPULeak, MCULeak, LCPULeak, MCPULeak, BCPULeak}). Initially, weights of the AI model MD_AI are set by random values. After the weights of the AI model MD_AI are updated iteratively via machine learning, the weights of the AI model MD_AI will be converged to the best approximation values gradually. When the weights of the AI model MD_AI change no more, the iteration is terminated, and the mapping relationship (i.e., inverse matrix $A^{-1}$ that is a matrix being an inverse of matrix $A$) is found by the AI-aided approach. It should be noted that this is for illustrative purposes only, and is not meant to be a limitation of the present invention. In practice, any means capable of finding the mapping relationship (i.e., inverse matrix $A^{-1}$ that is a matrix being an inverse of matrix $A$) falls within the scope of the present invention.

In a foundry, WAT is performed as defined by a predetermined WAT model that specifies a number of test sites. However, the number of WAT sites on a wafer is much smaller than the number of dies fabricated in the same wafer. Hence, measurement results of WAT sites fail to provide die-level electrical parameters of each die for certain applications such as leakage analysis. To address this issue, the mapping relationship (i.e., inverse matrix $A^{-1}$ that is a matrix being an inverse of matrix $A$) found at step 206 can be used to obtain electrical parameters in a die level.

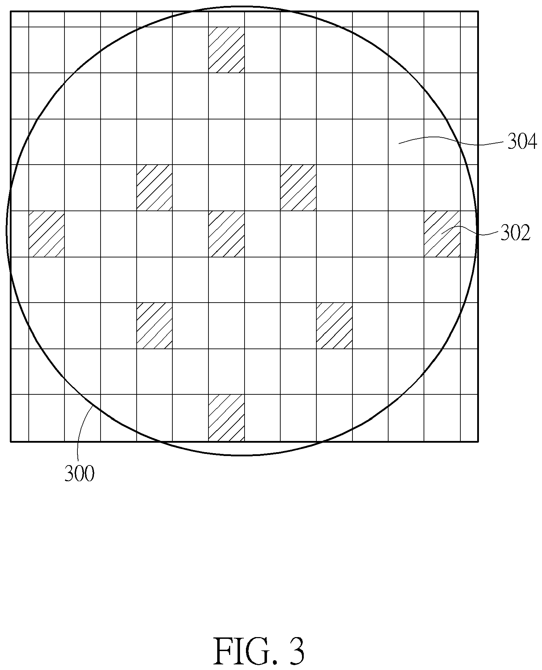

FIG. 3 is a diagram illustrating a concept of the proposed die-level electrical parameter extraction according to an embodiment of the present invention. The WAT data D_WAT provided by the foundry includes electrical parameters of different transistor types {SVT Iddq, LVT_LL Iddq, LVT Iddq, ULVT_LL Iddq, ULVT Iddq, ELVT Iddq} for each of the dies 302 at 9 WAT sites. However, the WAT data D_WAT does not provide electrical parameters of different transistor types {SVT Iddq, LVT_LL Iddq, LVT Iddq, ULVT_LL Iddq, ULVT Iddq, ELVT Iddq} for those dies 304 that are not at 9 WAT sites. Regarding any of the dies 304 of a wafer 300, the program code PROG running on the processor 102 obtains die-level measurement results of logic blocks (e.g., block leakage currents {CORELeak, GPULeak, MCULeak, LCPULeak, MCPULeak, BCPULeak}) that are measured for the die 304 during the CP process), and generate die-level electrical parameters of the transistor types (e.g., {SVT Iddq, LVT_LL Iddq, LVT Iddq, ULVT_LL Iddq, ULVT Iddq, ELVT Iddq}) for the die 304 according to the mapping relationship (e.g., inverse matrix $A^{-1}$ that is a matrix being an inverse of matrix $A$) obtained at step 206 and the die-level measurement results of logic blocks obtained from the CP process. Specifically, the same matrix formula (2) mentioned above can be used for generating die-level electrical parameters of the transistor types (e.g., {SVT Iddq, LVT_LL Iddq, LVT Iddq, ULVT_LL Iddq, ULVT Iddq, ELVT Iddq}) for the die 304 by performing matrix multiplication upon the inverse matrix $A^{-1}$ (which is a matrix being an inverse of matrix $A$) and the die-level measurement results (which are measured for the die 304 during the CP process).

The proposed die-level electrical parameter extraction methodology is capable of extracting leakage values of different transistor types (e.g., SVT, LVT_LL, LVT, ULVT_LL, ULVT, and ELVT) without extra CP testing pattern in the die level. In addition, the die-level leakage values of different transistor types can be used by die-level leakage analysis to partition the contribution of each transistor type in different use scenarios, such that a real root cause of the leakage issue can be found easily and efficiently.

Those skilled in the art will readily observe that numerous modifications and alterations of the device and method may be made while retaining the teachings of the invention. Accordingly, the above disclosure should be construed as limited only by the metes and bounds of the appended claims.

The present invention may also be defined by the following numbered clauses.

1. A die-level electrical parameter extraction method comprising:

obtaining electrical parameters of a plurality of transistor types;
obtaining measurement results of a plurality of logic blocks;
estimating a mapping relationship between the electrical parameters of the plurality of transistor types and the measurement results of the plurality of logic blocks; and
regarding a specific die of a wafer:

obtaining die-level measurement results of the plurality of logic blocks; and
generating die-level electrical parameters of the plurality of transistor types according to the mapping relationship and the die-level measurement results.

2. The die-level electrical parameter extraction method of clause 1, wherein obtaining the electrical parameters of the plurality of transistor types comprises:
obtaining the electrical parameters of the plurality of transistor types from a wafer-level process.

3. The die-level electrical parameter extraction method of clause 2, wherein the wafer-level process is a wafer acceptance test (WAT) process.

4. The die-level electrical parameter extraction method of clause 1, wherein obtaining the measurement results of the plurality of logic blocks comprises:
obtaining the measurement results of the plurality of logic blocks from a die-level measurement.

5. The die-level electrical parameter extraction method of clause 4, wherein the die-level measurement is a part of a chip probing (CP) process.

6. The die-level electrical parameter extraction method of clause 1, wherein each of the electrical parameters of the plurality of transistor types is an integrated circuit quiescent current (IDDQ) of a corresponding transistor type; and each of the measurement results of the plurality of logic blocks is a block leakage current of a corresponding logic block.

7. The die-level electrical parameter extraction method of clause 1, wherein each of the die-level measurement results of the plurality of logic blocks is a block leakage current of a corresponding logic block, and each of the die-level electrical parameters of the plurality of transistor types is an integrated circuit quiescent current (IDDQ) of a corresponding transistor type.

8. The die-level electrical parameter extraction method of clause 1, wherein the plurality of transistor types are differentiated by different threshold voltages.

9. The die-level electrical parameter extraction method of clause 1, wherein estimating the mapping relationship between the electrical parameters of the plurality of transistor types and the measurement results of the plurality of logic blocks comprises:
using an artificial intelligence (AI) model for learning the mapping relationship.

10. The die-level electrical parameter extraction method of clause 1, wherein the mapping relationship is represented by a matrix; and generating the die-level electrical parameters of the plurality of transistor types comprises:
performing matrix multiplication upon the matrix and the die-level measurement results to generate the die-level electrical parameters.

11. A non-transitory machine-readable medium for storing a program code, wherein when loaded and executed by a processor, the program code instructs the processor to perform following steps:

    obtaining electrical parameters of a plurality of transistor types;
    obtaining measurement results of a plurality of logic blocks;
    estimating a mapping relationship between the electrical parameters of the plurality of transistor types and the measurement results of the plurality of logic blocks; and
    regarding a specific die of a wafer:

        obtaining die-level measurement results of the plurality of logic blocks; and
        generating die-level electrical parameters of the plurality of transistor types according to the mapping relationship and the die-level measurement results.

12. The non-transitory machine-readable medium of clause 11, wherein obtaining the electrical parameters of the plurality of transistor types comprises:
obtaining the electrical parameters of the plurality of transistor types from a wafer-level process.

13. The non-transitory machine-readable medium of clause 12, wherein the wafer-level process is a wafer acceptance test (WAT) process.

14. The non-transitory machine-readable medium of clause 11, wherein obtaining the measurement results of the plurality of logic blocks comprises:
obtaining the measurement results of the plurality of logic blocks from a die-level measurement.

15. The non-transitory machine-readable medium of clause 14, wherein the die-level measurement is a part of a chip probing (CP) process.

16. The non-transitory machine-readable medium of clause 11, wherein each of the electrical parameters of the plurality of transistor types is an integrated circuit quiescent current (IDDQ) of a corresponding transistor type; and each of the measurement results of the plurality of logic blocks is a block leakage current of a corresponding logic block.

17. The non-transitory machine-readable medium of clause 11, wherein each of the die-level measurement results of the plurality of logic blocks is a block leakage current of a corresponding logic block, and each of the die-level electrical parameters of the plurality of transistor types is an integrated circuit quiescent current (IDDQ) of a corresponding transistor type.

18. The non-transitory machine-readable medium of clause 11, wherein the plurality of transistor types are differentiated by different threshold voltages.

19. The non-transitory machine-readable medium of clause 11, wherein estimating the mapping relationship between the electrical parameters of the plurality of transistor types and the measurement results of the plurality of logic blocks comprises:

using an artificial intelligence (AI) model for learning the mapping relationship.

20. The non-transitory machine-readable medium of clause 11, wherein the mapping relationship is represented by a matrix; and generating the die-level electrical parameters of the plurality of transistor types comprises: performing matrix multiplication upon the matrix and the die-level measurement results to generate the die-level electrical parameters.

**Claims**

1. A die-level electrical parameter extraction method comprising:

   obtaining electrical parameters of a plurality of transistor types;
   obtaining measurement results of a plurality of logic blocks;
   estimating a mapping relationship between the electrical parameters of the plurality of transistor types and the measurement results of the plurality of logic blocks; and
   regarding a specific die (302, 304) of a wafer (300):

      obtaining die-level measurement results of the plurality of logic blocks; and
      generating die-level electrical parameters of the plurality of transistor types according to the mapping relationship and the die-level measurement results.

2. The die-level electrical parameter extraction method of claim 1, wherein obtaining the electrical parameters of the plurality of transistor types comprises:
   obtaining the electrical parameters of the plurality of transistor types from a wafer-level process.

3. The die-level electrical parameter extraction method of claim 1, wherein obtaining the measurement results of the plurality of logic blocks comprises:
   obtaining the measurement results of the plurality of logic blocks from a die-level measurement.

4. The die-level electrical parameter extraction method of claim 3, wherein the die-level measurement is a part of a chip probing, CP, process.

5. The die-level electrical parameter extraction method of claim 1, wherein each of the electrical parameters of the plurality of transistor types is an integrated circuit quiescent current, IDDQ, of a corresponding transistor type; and each of the measurement results of the plurality of logic blocks is a block leakage current of a corresponding logic block; or
   wherein each of the die-level measurement results of the plurality of logic blocks is a block leakage current of a corresponding logic block, and each of the die-level electrical parameters of the plurality of transistor types is an integrated circuit quiescent current, IDDQ, of a corresponding transistor type.

6. The die-level electrical parameter extraction method of claim 1, wherein estimating the mapping relationship between the electrical parameters of the plurality of transistor types and the measurement results of the plurality of logic blocks comprises:
   using an artificial intelligence, AI, model for learning the mapping relationship.

7. The die-level electrical parameter extraction method of claim 1, wherein the mapping relationship is represented by a matrix; and generating the die-level electrical parameters of the plurality of transistor types comprises:
   performing matrix multiplication upon the matrix and the die-level measurement results to generate the die-level electrical parameters.

8. A non-transitory machine-readable medium for storing a program code, wherein when loaded and executed by a processor (102), the program code instructs the processor (102) to perform following steps:

   obtaining electrical parameters of a plurality of transistor types;
   obtaining measurement results of a plurality of logic blocks;
   estimating a mapping relationship between the electrical parameters of the plurality of transistor types and the measurement results of the plurality of logic blocks; and regarding a specific die (302, 304) of a wafer (300):

obtaining die-level measurement results of the plurality of logic blocks; and
generating die-level electrical parameters of the plurality of transistor types according to the mapping relationship and the die-level measurement results.

9. The non-transitory machine-readable medium of claim 8, wherein obtaining the electrical parameters of the plurality of transistor types comprises:
obtaining the electrical parameters of the plurality of transistor types from a wafer-level process.

10. The non-transitory machine-readable medium of claim 8 wherein obtaining the measurement results of the plurality of logic blocks comprises:
obtaining the measurement results of the plurality of logic blocks from a die-level measurement.

11. The non-transitory machine-readable medium of claim 10, wherein the die-level measurement is a part of a chip probing, CP, process.

12. The non-transitory machine-readable medium of claim 8, wherein each of the electrical parameters of the plurality of transistor types is an integrated circuit quiescent current, IDDQ, of a corresponding transistor type; and each of the measurement results of the plurality of logic blocks is a block leakage current of a corresponding logic block.

13. The non-transitory machine-readable medium of claim 8, wherein each of the die-level measurement results of the plurality of logic blocks is a block leakage current of a corresponding logic block, and each of the die-level electrical parameters of the plurality of transistor types is an integrated circuit quiescent current, IDDQ, of a corresponding transistor type.

14. The non-transitory machine-readable medium of claim 8, wherein estimating the mapping relationship between the electrical parameters of the plurality of transistor types and the measurement results of the plurality of logic blocks comprises:
using an artificial intelligence, AI, model for learning the mapping relationship.

15. The non-transitory machine-readable medium of claim 8, wherein the mapping relationship is represented by a matrix; and generating the die-level electrical parameters of the plurality of transistor types comprises:
performing matrix multiplication upon the matrix and the die-level measurement results to generate the die-level electrical parameters.

FIG. 1

```
        ┌─────────┐
        │  Start  │
        └────┬────┘
             │
             ▼
   ┌──────────────────────┐  ╱─202
   │ Obtain electrical    │
   │ parameters of        │
   │ transistor types     │
   └──────────┬───────────┘
              │
              ▼
   ┌──────────────────────┐  ╱─204
   │ Obtain measurement   │
   │ results of logic     │
   │ blocks               │
   └──────────┬───────────┘
```

Obtain electrical parameters of transistor types — 202

Obtain measurement results of logic blocks — 204

Estimate mapping relationship (e.g., inverse matrix) between electrical parameters of transistor types and measurement results of logic blocks — 206

Obtain die-level measurement of logic blocks in specific die, and generate die-level electrical parameters of transistor types for specific die according to mapping relationship (e.g., inverse matrix) and die-level measurement results — 208

End

FIG. 2

FIG. 3

Europäisches
Patentamt

European
Patent Office

Office européen
des brevets

# EUROPEAN SEARCH REPORT

Application Number

EP 23 17 8767

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/117163 A1 (NISHIMURA YASUMASA [JP]) 26 June 2003 (2003-06-26) * abstract; claims 1-5; figures 1-7 * * paragraph [0008] – paragraph [0011] * * paragraph [0022] – paragraph [0038] * | 1-15 | INV. G01R31/3185 G01R31/28 H01L21/66 |
| X | US 6 028 994 A (PENG YENG-KAUNG [US] ET AL) 22 February 2000 (2000-02-22) * abstract; claims 1-23; figures 1-9 * * column 2, line 28 – line 64 * * column 3, line 39 – column 9, line 3 * | 1-15 | |
| X | ES 2 178 554 A1 (LUCENT TECHNOLOGIES INC [US]) 16 December 2002 (2002-12-16) * claims 1-36; figures 1-5 * * column 2, line 38 – column 4, line 9 * * column 4, line 41 – column 10, line 57 * | 1-15 | |
| A | US 2020/049757 A1 (PARK HYUNWOO [US] ET AL) 13 February 2020 (2020-02-13) * abstract; claims 1-17; figures 1-5 * * paragraph [0008] – paragraph [0011] * * paragraph [0022] – paragraph [0038] * * paragraph [0006] – paragraph [0009] * * paragraph [0023] – paragraph [0040] * | 1-15 | TECHNICAL FIELDS SEARCHED (IPC)  G01R H01L |

The present search report has been drawn up for all claims

| Place of search | Date of completion of the search | Examiner |
|---|---|---|
| Munich | 27 November 2023 | Nadal, Rafael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 17 8767

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2023

| Patent document cited in search report | Publication date | Patent family member(s) | Publication date |
|---|---|---|---|
| US 2003117163 A1 | 26-06-2003 | JP 2003194885 A<br>US 2003117163 A1 | 09-07-2003<br>26-06-2003 |
| US 6028994 A | 22-02-2000 | NONE | |
| ES 2178554 A1 | 16-12-2002 | NONE | |
| US 2020049757 A1 | 13-02-2020 | TW 202014718 A<br>US 2020049757 A1<br>WO 2020033079 A1 | 16-04-2020<br>13-02-2020<br>13-02-2020 |

EPO FORM P0459

For more details about this annex : see Official Journal of the European Patent Office, No. 12/82

**REFERENCES CITED IN THE DESCRIPTION**

**Patent documents cited in the description**

- US 63388658